# EUROPÄISCHE PATENTANMELDUNG

(11) **EP 0 977 250 A2**
(43) Veröffentlichungstag der Anmeldung: **02.02.2000**
(21) Anmeldenummer: 99114471.8
(22) Anmeldetag: 23.07.1999
(51) Int. Cl.: H01L 21/331, H01L 29/737

(54) **Anordnung und Verfahren zur Herstellung eines Heterobipolartransistors**

(30) Priorität: 31.07.1998 DE 19834491
(71) Anmelder: DaimlerChrysler AG, 70567 Stuttgart (DE)
(72) Erfinder: Gässler, Christoph, 89160 Dornstadt (DE); Leier, Helmut, Dr., 73344 Gruibingen (DE); Shin, Hyunchol, Doosan Apt. 801-1801, Kyung Gi, 442-470 (KR)

(57) **Zusammenfassung**

Das Verfahren zur Herstellung eines auf einem Substrat aus Halbleitermaterial angeordneten Heterobipolartransistors, bei dem eine Halbleiterschichtenfolge für einen Kollektor, eine Basis und einem Emitter aufgewachsen wird, beinhaltet, daß der Transistor in Mesabauweise strukturiert wird, ein erster Planarisierungsschritt bis zur Obergrenze der Basis durchgeführt wird, wobei während diesem ersten Planarisierungsschritt die Oberfläche der Basis durch eine Schutzschicht der auf die Basis folgenden Emitterschicht geschützt wird, diese Schutzschicht abgetragen und ein Basismetall aufgebracht wird, ein zweiter Planarisierungsschritt über die Basis-Emitter-Mesa erfolgt, und eine Anschlußmetallisierung aufgebracht wird.

## Beschreibung

Die Erfindung bezieht sich aufein Verfahren zur Herstellung eines Heterobipolartransistors nach dem Oberbegriff des Patentanspruchs 1 und auf eine Anordnung eines Heterobipolartransistors nach dem Oberbegriff des Patentanspruchs 4.

Zur Herstellung von Hochfrequenz Schaltkreisen, wie beispielsweise Leistungsverstärker, Oszillatoren oder Mischer, sind Bauteile mit exzellenten Hochfrequenz-Eigenschaften erforderlich. Dabei stellt eine Erhöhung der Grenzfequenzen f_{T} und fₘₐₓ von Transistoren eine wichtige Voraussetzung für technische Innovationen bei Mobil- oder Kurzstrecken-Kommunikationssystemen sowie phasengesteuerten Antennen dar.

Bisher sind Transistoren aus der Schrift Shigematsu, H. et al.; IEEE Electron Device Letters, Vol. 16, No. 2, pp. 55-57, (1995) bekannt die das Herstellungsverfahren eines InP/InGaAs Heterobipolartransistors in Verbindung mit einem Polyimid-Planarisierungsprozeß zur Basiskontaktierung für einen Einsatz bei hohen Frequenzen beschreibt. Die Bauteilherstellung wird mittels einer Selbstjustage-Prozeßfolge an einer aufwendigen sog. Dummy-Emitter-Struktur und Spacern durchgeführt. Wünschenswert wäre eine möglichst einfache und in der Prozeßfolge zuverlässige Herstellungsmethode mit der sich parasitäre Kapazitäten erniedrigen lassen.

Bei den übrigen bekannten Verfahren, wie beispielsweise aus den Schriften Asbeck, P.M. et al.; IEEE Electron Device Letters, Vol. EDL-5, No. 8, pp. 310-312, (1984) und Ho, M.C. et al.; IEEE Electron Device Letters, Vol. 16; No. 11, pp. 512-514, (1995) zu entnehmen ist, wird mittels eines Implantationsverfahrens zur Isolation des extrinsischen Bereichs der Basis durchgeführt. Die Implantation bewirkt immer eine Schädigung dieses Bereichs der Basis, was eine unerwünschten Erhöhung der Basis-Kollektor-Kapazität und damit eine Verschlechterung der Hochfrequenz-Eigenschaften eines Transistors zur Folge hat.

Der Erfindung liegt die Aufgabe zugrunde, ein Verfahren und eine Anordnung anzugeben, mit dem eine Optimierung der Hochfrequenz-Eigenschaften eines Heterobipolartransistors durch Minimierung der parasitären Basis-Kollektor-Kapazität erreicht wird, um eine Steigerung der Grenzfequenzen f_{T} und fₘₐₓ zu bewirken.

Die Erfindung wird in Bezug aufdas Verfahren durch die Merkmale des Patentanspruchs 1 und in Bezug aufdie Anordnung eines Heterobipolartransistors durch die Merkmale des Patentanspruchs 4 wiedergegeben. Die weiteren Ansprüche enthalten vorteilhafte Aus- und Weiterbildungen der Erfindung.

Die Erfindung beinhaltet ein zweistufiges Verfahren zur Planarisierung einer Halbleiteroberfläche mit Polyimid, bei dem, gegenüber dem Stand der Technik, eine potentielle Schädigung des extrinsischen Bereichs der Basis verhindert wird. Der Verfahrensablaufbeinhaltet das Aufwachsen einer Schichtenfolge auf einem Substrat aus Halbleitermaterial, bei dem übereinander Schichten für einen Kollektor, eine Basis und einem Emitter abgeschieden werden.
Der Transistor wird anschließend in Mesabauweise strukturiert.
Danach wird ein erster Planarisierungsschritt bis zur Basis-Mesa durchgeführt, wobei während diesem ersten Planarisierungsschritt ein Rest der darauffolgenden Emitterschicht die Oberfläche der Basis schützt. Anschließend wird diese Schutzschicht beispielsweise durch eine schädigungsarme naßchemische Ätzung abgetragen und die Metallisierung der Basis aufgebracht. Die Basis-Mesa ist außerordentlich schmal dimensioniert, so daß sich das Basismetall lateral auf die erste Planarisierungsschicht ausdehnt und insbesondere eine Metalleiterbahn zur Anschlußkontaktierung über die Planarisierungsschicht geführt wird. Eine ebene Halbleiteroberfläche wird durch einen zweiten Planarisierungsschritt bis über die Emitter-Mesa erzeugt.

Ein besonderer Vorteil der Erfindung besteht darin, daß die Optimierung der Hochfrequenz-Eigenschaften eines Transistors durch die Minimierung der parasitären Basis-Kollektor-Kapazität C_{BC} erreicht wird, indem einerseits die Basissehichten während der Prozessierung geschützt werden und die Basis entsprechend schmal dimensioniert wird.
Ein weiterer Vorteil bei der Planarisierung ergibt sich aus den technologisch gut kontrollierbaren Einzelschritten der Prozeßfolge, wobei die Materialauswahl beispielsweise nicht auf InP beschränkt ist, sondern auch für andere Halbleiterschichtenfolgen anwendbar ist.
Im folgenden wird die Erfindung anhand von vorteilhaften Ausführungsbeispielen unter Bezugnahme auf schematische Zeichnungen in den Figuren näher erläutert. Es zeigen:
- Fig. 1: Schichtenfolge des Heterobipolartransistors,
- Fig. 2: Selbstjustage des Emitters,
- Fig. 3: Herstellung der Basis-Kollektor-Mesa,

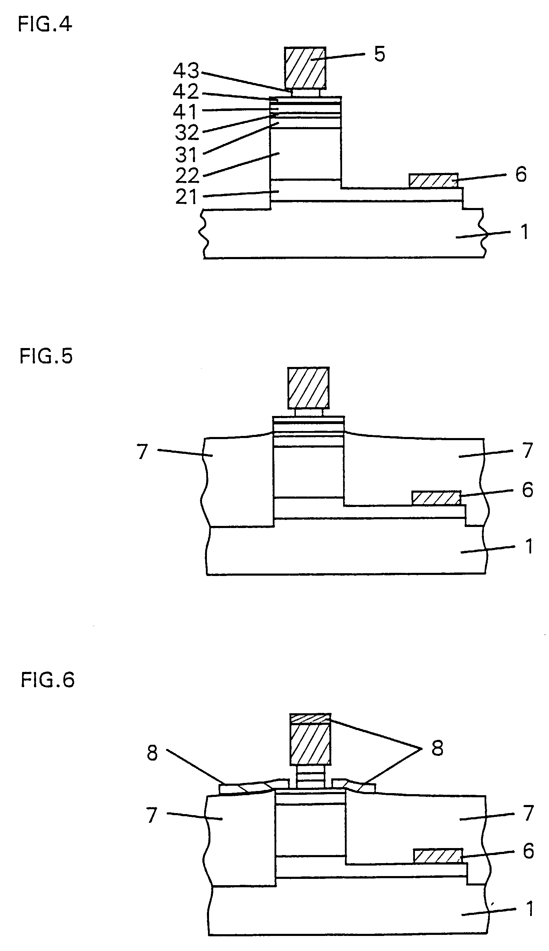

- Fig. 4: Mesabauweise des Transistors,
- Fig. 5: erster Planarisierungsschritt bis zur Basis-Mesa mit Rest der auf die Basis folgenden Emitterschicht,
- Fig. 6: Metallisierung der Basis,
- Fig. 7: zweiter Planarisierungsschritt über die Emitter-Basis-Mesa,
- Fig. 8: Kontaktieren von Emitter, Basis und Kollektor,.
- Fig. 9: Transistoraufbau mit Mesastruktur in Projektion.

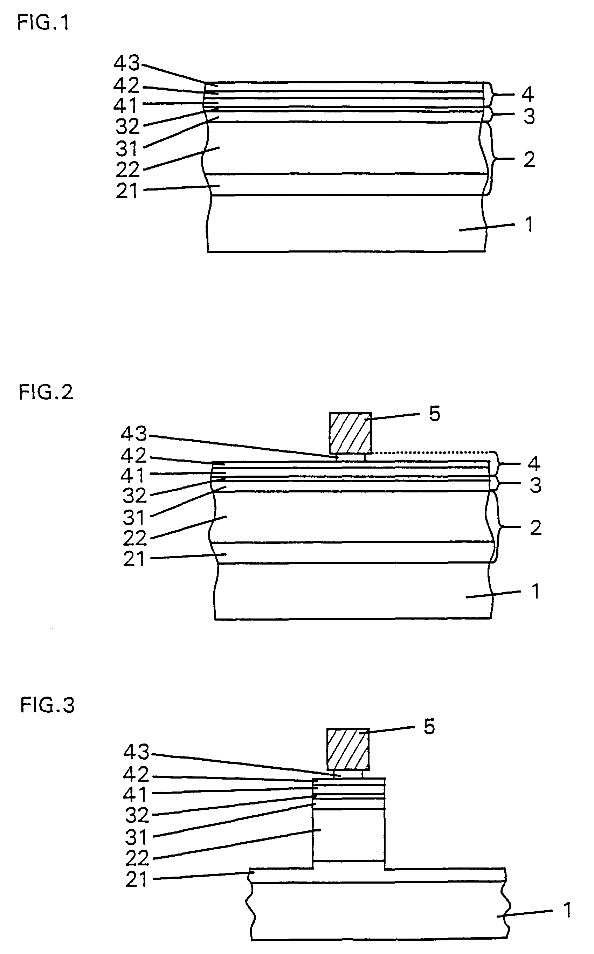

In einem ersten Ausführungsbeispiel gemäß Fig. 1 wird eine Schichtenfolge eines InP/InGaAs Heterobipolartransistors mittels Molekularstrahlepitaxie auf 2 Zoll halbisolierendem InP Substrat 1 aufgewachsen. Im einzelnen besteht die Schichtenfolge aus:
- einer InGaAs n⁺-Subkollektorschicht 21 einer Dicke von 600 nm und der Dotierkonzentration von ca. 1x10¹⁹ cm⁻³,
- einer InGaAs n-Kollektorschicht 22 einer Dicke von 500 nm und der Dotierkonzentration von ca. 1x10¹⁶ cm⁻³,
- einer InGaAs p⁺-Basisschicht 31 einer Dicke von 90 nm und der Be- oder C-Dotierkonzentration von ca. 4x10¹⁹ cm⁻³,
- einer InGaAs intrinsischen Basisspacerschicht 32 einer Dicke von 7 nm,
- einer InP n-Emitterschicht 41 einer Dicke von 60 nm und der Dotierkonzentration von ca. 3x10¹⁷ cm⁻³,
- einer ersten n⁺-Emittercapschicht 42 aus InP einer Dicke von 50 nm und der Dotierkonzentration von ca. 1x10¹⁹ cm⁻³,
- einer zweiten n⁺-Emittercapschicht 43 aus InGaAs einer Dicke von 180 nm und der Dotierkonzentration von ca. 1x10¹⁹ cm⁻³.

Die Bauteilherstellung mit der zugrundegelegten Schichtenfolge gemäß Fig. 1 beginnt mit der Emittermetallisierung 5, die bevorzugt aus der Metall-Schichtenfolge Ti/Pt/Au aufgebaut ist. Die zweite n⁺-Emittercapschicht 43 aus InGaAs wird anschließend abgeätzt, wobei die vorausgehende Emittermetallisierung 5 als selbstjustierende Ätzmaske dient. Die InP n-Emitterschicht 41 und erste n⁺-Emittercapschicht 42 aus InP verbleiben als Schutzschichten über der InGaAs-Basis 31 und 32 zunächst ganzflächig erhalten.

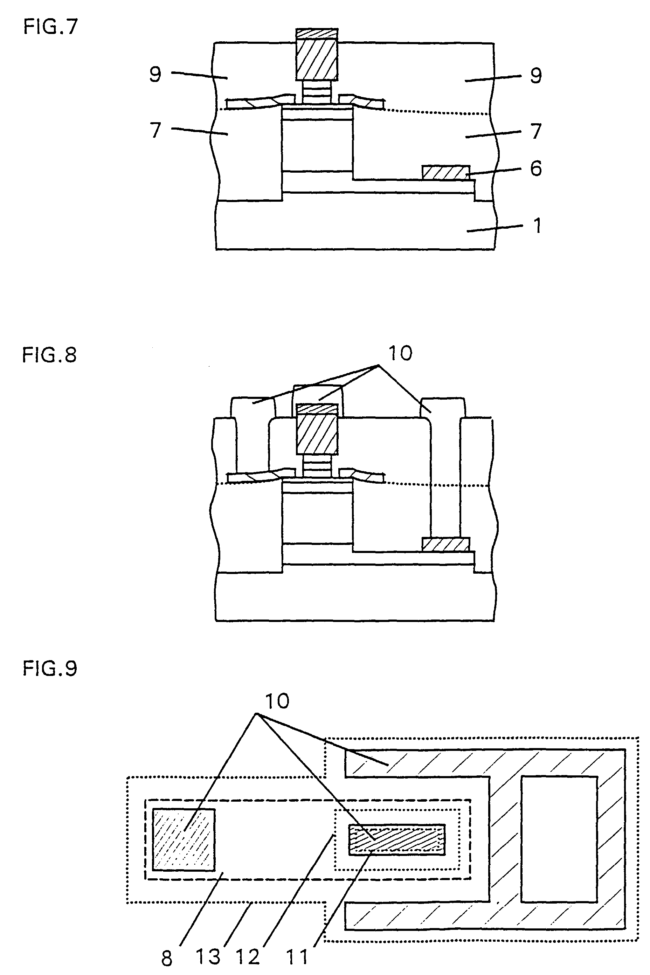

Die Herstellung einer außerordentlich schmal dimensionierten Basis-Kollektor-Mesa 12 (Fig.9), die bis in die n⁺-Subkollektorschicht 21 reicht, wird mit einer Photolackmaske durchgeführt. Dabei wird für die InP Schichten 41 und 42 ein chemisch unterstütztes Ionenstrahl Ätzverfahren (CAIBE) gewählt, bei dem eine Prozeßgasmischung Cl₂/Ar zum Abtrag verwendet wird. Die InGaAs-Schichten 21, 22, 31 und 32 werden naßchemisch mit einer Phosphorsäure-Wasserstoff-Peroxid-Mischung (H₃PO₄ : H₂O₂:H₂O) abgetragen. Die nachfolgende Herstellung einer Kollektor-Substrat-Mesa 13, die bis in das Substrat 1 reicht, dient zur Isolation des Bauteils. Außerdem wird mittels einer Photolackmaske das Kollektormetall 6 aufgebracht.
Anschließend wird ein erster Planarisierungsschritt durchgeführt, bei dem die Halbleiteroberfläche bis zur Obergrenze der Basis abgedeckt wird. Hierzu wird eine erste Polyimidschicht 7 aufgebracht, die mittels eines reaktiven Ionenätzverfahrens (RIE) im Sauerstoffplasma bis zur Obergrenze der Basis zurückgeätzt wird. Die InP Schutzschicht 41 und 42 ist für das Rückätzen der Polyimidschicht 7 von zentraler Bedeutung. Danach wird die InP n-Emitterschicht 41 und erste n⁺-Emittercapschicht 42 aus InP mit einer auf Salzsäure basierenden Ätzlösung abgetragen und unmittelbar danach das Basismetall 8 selbstjustierend gegenüber der Emitter-Basis-Mesa 11 aufgebracht. Dabei erstreckt sich das Basismetall 8 lateral auf die erste Planarisierungsschicht, wobei insbesondere diese als Metalleiterbahn zur Anschlußkontaktierung über die erste Polyimidschicht 7 weitergeführt wird.

Mit einem zweiten Planarisierungsschritt wird die Halbleiteroberfläche bis zur Obergrenze des Emitters abgedeckt. Hierzu wird wiederum eine zweite Polyimidschicht 9 aufgebracht, die im Sauerstoffplasma bis zur Obergrenze des Emitters zurückgeätzt wird. Der letzte Prozeßschrift beinhaltet die Anschlußmetallisierung 10 von Emitter 4, Basis 3 und Kollektor 2 mittels reaktivem Ionenätzen und einer elektrochemischen Abscheidung von Gold an den dafür vorgesehen Bereichen.
Eine Verbesserung der Hochfrequenz-Eigenschaften eines Transistors durch eine Verringerung der parasitären Basis-Kollektor-Kapazität C_{BC} um bis zu 56% und infolge dessen eine beträchtliche Steigerung der Grenzfrequenzen f_{T} und fₘₐₓ um bis zu 35% wurden beobachtet.
In einem zweiten Ausführungsbeispiel können, unter Zugrundelegen der nach Ausführungsbeispiel 1 verwendeten Prozeßfolge, die Halbleiterschichtenfolge variiert werden. Beispielsweise kann auch auf die InGaAs intrinsische Basisspacerschicht 32 und/oder die erste n⁺-Emittercapschicht 42 aus InP verzichtet werden. Weiterhin können die n-Emitterschicht 41 und die erste n⁺-Emittercapschicht 42 auch aus InAlAs bestehen.

In einem dritten Ausführungsbeispiel wird eine Schichtenfolge eines GaAs/AlGaAs Heterobipolartransistors mittels Molekularstrahlepitaxie auf halbisolierendem GaAs Substrat 1 aufgewachsen. Im einzelnen besteht die Schichtenfolge aus:
- einer GaAs n⁺-Subkollektorschicht 21 einer Dicke von 600 nm und der Dotierkonzentration von ca. 5x10¹⁸ cm⁻³,
- einer GaAs n-Kollektorschicht 22 einer Dicke von 500 nm und der Dotierkonzentration von ca. 1x10¹⁶ cm⁻³,
- einer GaAs p⁺-Basisschicht 31 einer Dicke von 90 nm und der Be- oder C-Dotierkonzentration von ca. 4x10¹⁹ cm⁻³
- einer GaAs intrinsischen Basisspacerschicht 32 einer Dicke von 7 nm,
- einer AlGaAs n-Emitterschicht 41, mit einem Al-Gehalt zwischen 25%-35%, einer Dicke von 60 nm und der Dotierkonzentration von ca. 3x10¹⁷ cm⁻³,
- einer ersten n⁺-Emittercapschicht 42 aus GaAs einer Dicke von 200 nm und der Dotierkonzentration von ca. 5x10¹⁸ cm⁻³.

Optional kann auf der ersten n⁺-Emittercapschicht 42 eine zweite n⁺-Emittercapschicht 43 aus InGaAs einer Dicke von 20 nm und der Dotierkonzentration von ca. 1x10¹⁹ cm⁻³ folgen, wobei der In-Gehalt in der Schicht einen Gradienten zwischen 0 % bis 50 % aufweist. Ebenso kann zwischen der n-Emitterschicht 41 und der ersten n⁺-Emittercapschicht 42 eine AlGaAs n-Schicht, mit einen Gradienten im Al-Gehalt zwischen 30 % bis 0 % verwendet werden, mit einer Dicke von 30 nm und der Dotierkonzentration von ca. 1x10¹⁸ cm⁻³.

## Patentansprüche

1. Verfahren zur Herstellung eines aufeinem Substrat (1) aus Halbleitermaterial angeordneten Heterobipolartransistors, bei dem eine Halbleiterschichtenfolge für einen Kollektor (2), eine Basis (3) und einem Emitter (4) aufgewachsen wird, dadurch gekennzeichnet,
- daß der Transistor in Mesabauweise strukturiert wird,
- daß ein erster Planarisierungsschritt bis zur Obergrenze der Basis (3) durchgeführt wird, wobei während diesem ersten Planarisierungsschritt die Oberfläche der Basis durch eine Schutzschicht (41, 42) der aufdie Basis folgenden Emitterschicht geschützt wird,
- daß diese Schutzschicht (41, 42) abgetragen und ein Basismetall (8) aufgebracht wird,
- daß ein zweiter Planarisierungsschritt über die Basis-Emitter-Mesa (11) erfolg, und
- daß eine Anschlußmetallisierung (10) aufgebracht wird.

2. Verfahren nach Anspruch 1, dadurch gekennzeichnet, daß beim ersten und zweiten Planarisierungsschritt Polyimidschichten (7, 9) verwendet werden.

3. Verfahren nach Anspruch 1, dadurch gekennzeichnet, daß das Basismetall (8) lateral über die Basis-Kollektor-Mesa (12) hinaus auf auf Bereiche der ersten Planarisierungsschicht (7) abgeschieden wird.

4. Heterobipolartransistor, hergestellt nach einem der Ansprüche 1 bis 3, dadurch gekennzeichnet, daß die Halbleiterschichtenfolge aus
- einer InGaAs n⁺-Subkollektorschicht (21),
- einer InGaAs n-Kollektorschicht (22),
- einer InGaAs p⁺-Basisschicht (31),
- einer InGaAs intrinsischen Basisspacerschicht (32),
- einer InP n-Emitterschicht (41),
- einer ersten n⁺-Emittercapschicht (42) aus InP,
- einer zweiten n⁺-Emittercapschicht (43) aus InGaAs auf dem Substrat (1) aus halbisolierendem InP besteht.

5. Heterobipolartransistor nach Anspruch 4, dadurch gekennzeichnet, daß die Schutzschicht aus der InP n-Emitterschicht (41) und der ersten n⁺-Emittercapschicht (42) aus InP besteht.

6. Heterobipolartransistor, hergestellt nach einem der Ansprüche 1 bis 3, dadurch gekennzeichnet, daß die Halbleiterschichtenfolge aus
- einer InGaAs n⁺-Subkollektorschicht (21),
- einer InGaAs n-Kollektorschicht (22),
- einer InGaAs p⁺-Basisschicht (31),
- einer InGaAs intrinsischen Basisspacerschicht (32),
- einer InP n-Emitterschicht (41),
- einer zweiten n⁺-Emittercapschicht (43) aus InGaAs aufdem Substrat (1) aus halbisolierendem InP besteht.

7. Heterobipolartransistor nach Anspruch 6, dadurch gekennzeichnet, daß die Schutzschicht aus der InP n-Emitterschicht (41) besteht.

8. Heterobipolartransistor, hergestellt nach einem der Ansprüche 1 bis 3, dadurch gekennzeichnet, daß die Halbleiterschichtenfolge aus
- einer GaAs n⁺-Subkollektorschicht (21),
- einer GaAs n-Kollektorschicht (22),
- einer GaAs p⁺-Basisschicht (31),
- einer GaAs intrinsischen Basisspacerschicht (32),
- einer AlGaAs n-Emitterschicht (41),
- einer ersten n⁺-Emittercapschicht (42) aus GaAs, auf dem Substrat (1) aus halbisolierendem GaAs besteht.

9. Heterobipolartransistor nach Anspruch 8, dadurch gekennzeichnet, daß auf der ersten n⁺-Emittercapschicht (42) eine zweite n⁺-Emittercapschicht (43) aus InGaAs folgt, wobei der In-Gehalt in der Schicht einen Gradienten zwischen 0 % bis 50 % aufweist.

10. Heterobipolartransistor nach Anspruch 8 oder 9, dadurch gekennzeichnet, daß zwischen der n-Emitterschicht (41) und der ersten n⁺-Emittercapschicht (42) eine AlGaAs n-Schicht, mit einen Gradienten im Al-Gehalt zwischen 30 % bis 0 % angeordnet ist.

11. Heterobipolartransistor, hergestellt nach einem der Ansprüche 1 bis 3, dadurch gekennzeichnet, daß das Basismetall (8) lateral über die Basis-Kollektor-Mesa (12) hinaus auf Bereiche der ersten Planarisierungsschicht (7) erstreckt.
